# EUROPEAN PATENT SPECIFICATION

(11) **EP 2 622 239 B1**
(45) Date of publication and mention of the grant of the patent: **05.11.2014**
(21) Application number: 11770040.1
(22) Date of filing: 27.09.2011
(51) Int. Cl.: F16D 61/00, F16D 65/092, F16D 65/78, H01L 35/00

(54) **ENERGY-RECOVERING BRAKE PAD**
BREMSBELAG MIT EINERGIERÜCKGEWINNUNG
PLAQUETTE DE FREIN À RÉCUPÉRATION D'ÉNERGIE

(30) Priority: 29.09.2010 DK 201070412
(43) Date of publication of application: 07.08.2013
(73) Proprietor: Aalborg Universitet, 9220 Aalborg (DK)
(72) Inventor: MORTENSEN, Paw Vestergård, 9800 Hjørring (DK); ENKESHAFI, Ali Asghar, 9200 Aalborg SV (DK); ROSENDAHL, Lasse, Aistrup, 9210 Aalborg SØ (DK)
(74) Representative: Plougmann & Vingtoft A/S
(86) International application number: PCT/DK2011/050361
(87) International publication number: WO 2012/041321

(56) References cited:
- EP-A1- 1 908 981
- WO-A1-2010/109592
- DE-A1-102008 057 568
- JP-A- 1 022 657
- JP-A- 4 351 333
- JP-A- 58 037 329
- US-A- 4 016 533

## Description

### Field of the invention

The present invention relates to a system for recovering waste energy from brake pads of a vessel or a plant and more particularly to a system adapted to use the waste energy to charge a battery or capacitor of the vessel or of the plant.

### Background of the invention

Disc brake systems are widely used in the automotive industry, wind turbine industry, railway industry, in small vessels such as trolleys for transporting goods and/or persons, etc.. Such disc brake systems typically comprise three major components: a rotating brake disc, a brake pad and a brake body. The brake body comprises a brake caliper and means such as mechanically operated, hydraulically operated or pneumatically operated means for applying a force on the brake pad towards the brake disc to slow down the rotation of the brake rotor by friction.

Friction causes the brake disc to stop during conversion of rotational energy into thermal energy, i.e., heat. The heat dissipated during braking is waste heat and presents a potential risk to the brake system if the temperature reaches critical material or system temperatures of the brake body and/or of the brake pads of the brake system. Therefore, efforts to actively cool the brake disc and/or the brake pads is well known in the field of brake systems.

US 6,386,333 discloses a disc brake system comprising a piston pump which produces a very rapid flow of brake fluid through the brake lines and calipers.

US 4,013,146 discloses a brake disc for railway vehicle disc brakes that has a friction ring traversed by radial cooling ducts formed by a plurality of ribs. A radial impeller is mounted in the space radially inwardly of the friction ring and the impeller has an axial intake and a radial outlet directed toward the cooling air ducts.

JP 58 037329 discloses heat recovery type pad characterized by P type and N type elements in contact to a brake pad through a back metal and a very thin paint for electrical insulation In that, heat transfer from the pad to the P and N type elements is achieved through the back metal and paint.

### Object of the invention

An improved brake system which can remove heat from the brake more efficiently would therefore be advantageous and especially a brake system which is capable of cooling components of the brake system without using extra energy in the form of electrical power or fuel consumption.

### Summary of the invention

The above described object and several other objects are solved in a first aspect of the invention by providing a system for producing electricity in a vessel or in a plant from excess heat generated on the surface of a brake pad of the vessel or of the plant, comprising a thermoelectric generator brake pad having a first side facing a brake rotor and a second side in thermal contact with a brake body.

The invention provides a brake pad for use in disc brake systems or drum brake system. The brake pad comprises build-in p- and n-type semiconductor legs. By incorporating p- and n-type semiconductor legs into the brake pad, the heat generated at the surface of the brake pad is passed more efficiently away from the surface of the brake disc or the brake rotor, but at the same time the brake pad is generating electrical power that may be used to charge a battery or a capacitor of the vessel or of the plant.

Charging a battery or a capacitor of a vessel result in a decreased fuel consumption of a vessel, which is fully or partly powered by fuel. If the vessel is fully powered by electricity, the cruising range of the vessel may be increased.

Charging a battery or a capacitor of a plant result in an increased safety during operation of the plant in case the plant have a failsafe brake system being electrically powered such as may be the case in brake systems of wind turbines.

The invention may be provided so that a brake pad, in itself constituting an aspect of the invention, is capable of being fitted and used in different brake systems with different dimensions, such as brake systems in different brands in the automotive industry, wind turbine industry or railway industry.

It is to be understood, that when using the phrase "brake pad" the phrase covers any shape or type of a brake pad for use in braking systems. Todays brake systems are mainly disc type brake systems, but the invention should not be confined to such systems since alternate brake type systems such as drum brakes and tread brakes also makes use of brake pads of the present invention.

It is to be understood, that when using the phrase "brake body" the phrase covers any shape or type means for arranging a brake pad and brake piston so the brake pad can be forced towards the brake rotor in a brake system. Brake bodies typically comprise a brake caliper and means for fixing the brake to the vessel or the plant in which the brake system is installed.

It is to be understood, that when using the phrase "thermoelectric generator element" the phrase covers any type of element that is able of converting a thermal gradient into an electrical current. These types of elements are referred to by various terms such as thermoelectric generators, Seebeck elements, Peltier elements, Thomson effect elements, thermopower elements, thermoelectric coolers and thermoelectric heaters.

According to a preferred embodiment of the invention, the thermoelectric generator brake pad comprises a plurality of thermoelectric generator elements.

By using a plurality of thermoelectric generator elements the output from the thermoelectric generator brake pad can be controlled in terms of current and voltage, because the thermoelectric generator elements each present a certain output and when positioned electrically in series, they will produce an output according to to the number and characteristics of thermoelectric elements used.

According to a yet a preferred embodiment of the invention, the thermoelectric generator elements are integral parts of the brake pad of the vessel or of the plant.

By integrating the thermoelectric generator elements into the brake pad a more mechanically stable brake pad is obtained. Furthermore, the thermal conductivity of the brake pad improves, which is a desired characteristic both in view of the objects of the present invention and in view of brake pads in general.

According to an embodiment of the invention, the thermoelectric generator elements are p and n semiconductor legs.

In appropriate configurations p- and n-type semiconductor materials are used as the thermoelectric generator elements. By alternating p- and n-type materials connected electrically in series and placing all p- and n-type materials in parallel the power generated from each element can be accumulated from the entire plurality of thermoelectric generator elements.

According to an embodiment of the invention, the system comprises a plurality of thermal connection elements having a first side in thermal contact with the thermoelectric generator p and n semiconductor legs and a second side in thermal contact with the brake rotor when the vehicle brake pad engages the brake rotor during braking of the vessel itself, during braking of a rotating component of the vessel, or during braking of a rotating component of the plant.

In order to fully utilize the generated heat from the surface of the brake pad, the heat is passed through thermal connection elements to the thermoelectric generator elements. The braking process using a disc brake is in many applications a very short process and involves a large development of heat within a very short period of time. Therefore, it may be essential to embodiments of the invention to be able to transfer the heat very quickly to the thermoelectric generator elements in order to exploit the largest possible amount of the generated heat before it dissipates to other areas of the brake system or to the surroundings.

According to an embodiment of the invention, the plurality of thermal connection elements are made from a highly thermoconductive material, preferably a metal, and even more preferably a metal selected from the group of copper, aluminium, iron or alloys or combinations of said materials.

Because the material of thermal connection elements constitutes part of the brake pad surface facing the brake rotor, the material of the thermal connection elements is also chosen for optimized braking characteristics, i.e., the friction coefficient between rotor and brake pad thermal connection element material.

According to another embodiment of the invention the system comprises a converter in electrical connection with the thermoelectric generator and a battery or a capacitor of the vessel or a battery or a capacitor of the plant.

According to another embodiment of the invention the system comprises a wear sensor, which is capable of feeding back a signal to an electrical system of the vessel or of the plant, said signal indicating that the brake pad is too thin for proper braking of the vessel itself, or for proper braking of a rotating component of a plant, and should be changed due to wear.

To allow for a timely replacement of the brakepad to ensure safety of the vessel or the plant, the brake pad may in some embodiments of the invention comprise a wear sensor, which can indicate when the brake pad has become too thin from wear and must be replaced.

According to an embodiment of the invention, the system comprises a temperature sensor, which is capable of providing an indication of a temperature of the first side of said thermoelectric generator brake pad. The system further comprises a control element, said control element capaable of communicating with the temperature sensor, and said control element capable of switching between two operating modes, and where the thermoelectric generator is capable of generating electricity in a first mode being a charging mode and of controlling the temperature of the vehicle brake pad in a second mode being a temperature control mode.

To ensure that the thermoelectric generator elements do not suffer from overheating, which may lead to a degredation of the efficiency of the elements, the brake pad may in some embodiments of the invention comprise a temperature sensor, which can feed back a signal to the electrical system of the vessel or the plant indicating elevated or critical temperatures.

The different aspects of the present invention may each be combined with any of the other aspects. These and other aspects of the invention will be apparent from and elucidated with reference to the embodiments described hereinafter.

Throughout this document the terms "comprising" or "comprises" do not exclude other possible elements or steps. Also, the mentioning of references such as "a" or "an" etc. should not be construed as excluding a plurality.

### Brief description of the drawings

The system according to the invention will now be described in more detail with regard to the accompanying figure. The figure show one way of implementing the present invention and is not to be construed as being limiting to other possible embodiments falling within the scope of the attached claim set.
Figure 1 is an exploded view of an embodiment of the invention.
Figure 2 is a schematic view of a typical disc brake system.
Figure 3 is a diagram of an embodiment of the invention.

### Embodiments of the invention

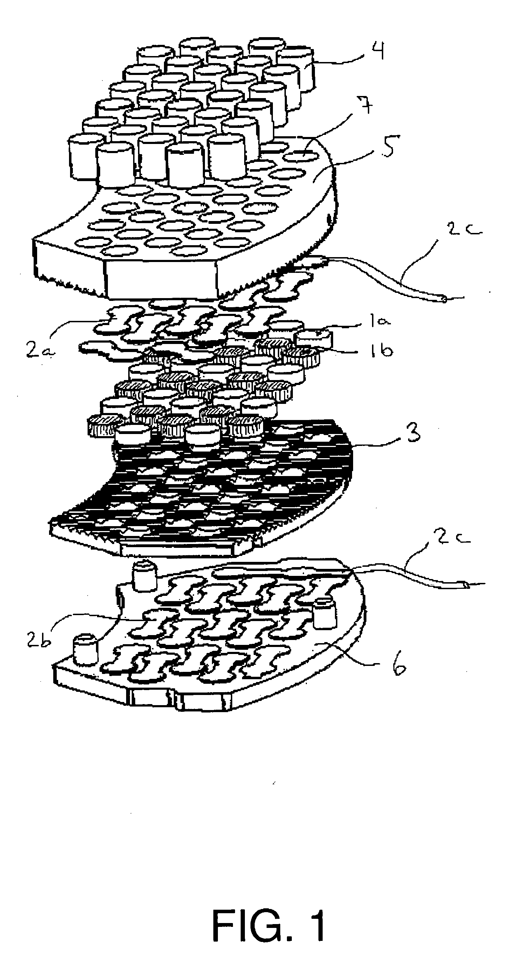

Figure 1 shows an embodiment of a system for producing electricity during braking of a disc brake rotor from excess heat generated on the surface of a brake pad. The system comprises a plurality of thermoelectric generator elements 1. The thermoelectric generator elements are electrically connected by a plurality of electrical connections 2 and fixed in position by a fixation element 3. In the embodiment shown in figure 1 the fixation element 3 is mounted on a bottom plate 6. The part of the brake pad facing the disc rotor 10 comprises a wear plate 5 with a plurality of embedded thermal connection elements 4.

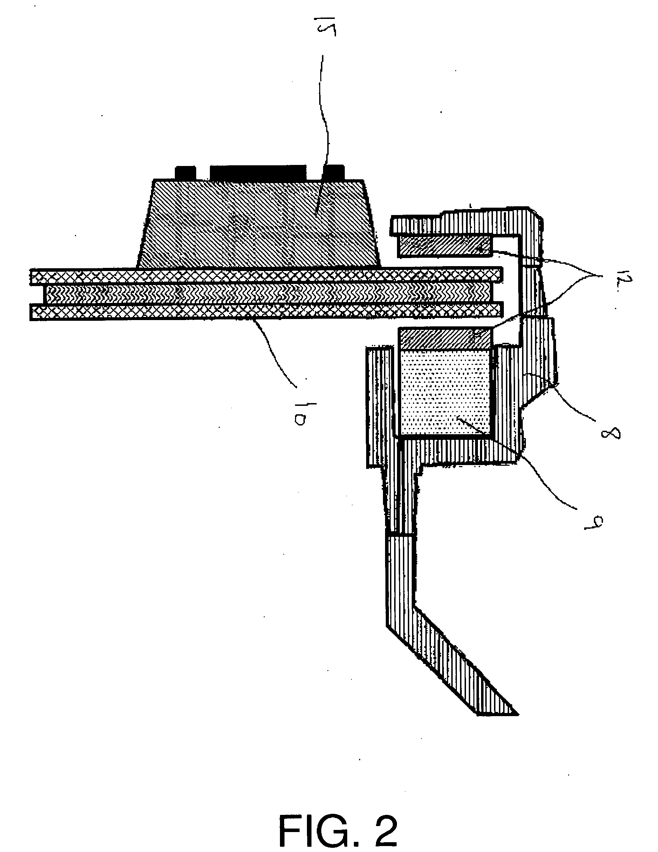

Figure 2 shows a schematical drawing of a typical disc brake system. Such a disc brake system comprises a disc brake caliper 8 also commonly referred to as the brake housing, which is the element of the brake fixing the brake pads in a position, so that they can be forced against the disc brake rotor 10 typically by using a mechanically, hydraulically, pneumatically or electromagnetically driven piston 9.

The thermoelectric generator elements 1 may be made from thermoelectric materials, that are able to withstand the relatively high temperatures of the brake pads. In some embodiments, thermoelectric generator elements may be manufactured from thermoelectric materials that are able to withstand temperatures at least as high as 800 degrees Celsius, and which may be able to withstand temperatures as high as 1100 degrees Celsius, or even higher temperatures. Such high temperature thermoelectric materials may include known high temperature thermoelectric materials (such as, but not limited to, cobalt-calcium compounds, aluminium and gallium doped zincoxide compounds, zinc alloys, cobalt antimony compounds, Zintl phase systems, yttrium manganese antimony compounds), as well as later-developed high temperature thermoelectric materials.

The electrical connections 2a, 2b, 2c may be made from any electrically conducting material and represents the electrical connection between n-type 1a and p-type 1b thermoelectric generator elements 1 and furthermore the electrical connection 2c from the thermoelectric generator element 1 to the electrical system taking the power generated by the thermoelectric generator elements 1.

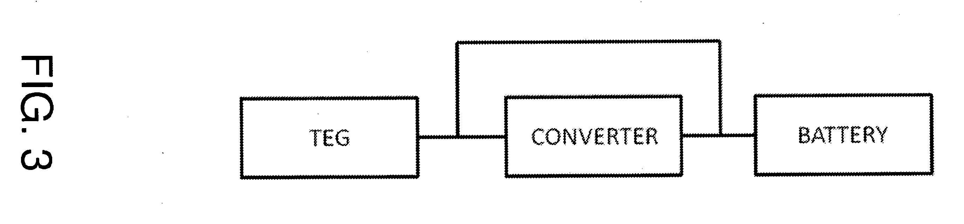

Figure 3 is a diagram of an embodiment of the invention. The electrical power generated by thermoelectric generators may be converted into an appropriate current and voltage by a converter 13 and thereafter used for example to charge a battery 14 of a vehicle or another type of electrical storage unit (e.g. a capacitor or a flywheel etc.). The battery 14 may in one embodiment be a separate battery specifically used for the storing of the electrical power generated by the thermoelectric generator elements 1.

The choice of material or materials, for the thermoelectric generator elements 1 may comprise multiple pieces of thermoelectric materials cascaded together, or otherwise arranged in whatever manners are suitable for generating electricity from the brake pad.

In an embodiment of the invention the elements of the invention shown in figure 1 is dimensioned so the thermoelectric generator brake pad fits a conventional brake body without further modification of the brake body. This embodiment allows the invention to be implemented in existing brake systems easily and cheaply.

Although the present invention has been described in connection with the specified embodiments, it should not be construed as being in any way limited to the presented examples. The scope of the present invention is set out by the accompanying claim set.

The use of reference signs in the claims with respect to elements indicated in the figures shall also not be construed as limiting the scope of the invention. Furthermore, individual features mentioned in different claims, may possibly be advantageously combined, and the mentioning of these features in different claims does not exclude that a combination of features is not possible and advantageous.

## Claims

1. A system for producing electricity in a vessel or in plant, said system comprising;
- a thermoelectric generator brake pad (12) having a first side facing a brake rotor (10) rotating during operation of the vessel or of the plant, and said thermoelectric generator brake pad (12) having a second side in thermal contact with a brake body,
- said thermoelectric generator brake pad comprising a plurality of thermoelectric generator elements (1) producing electricity from heat generated on the surface of a brake pad when being in contact with said rotating brake rotor (10),
- a plurality of thermal connection elements (4) having a first side in thermal contact with the thermoelectric generator p (1a) and n (1b) semiconductor legs and a second side in thermal contact with the brake rotor when the vehicle brake pad engages the brake rotor (10) during braking of the vessel itself or during braking of a component of the vessel or of the plant,
- said system adapted to produce electricity during braking of the brake rotor resulting in transfer of heat from the first side of the brake pad to the second side of the brake pad and further on to the brake body; wherein the system further comprises;
- a temperature sensor capable of providing an indication of a temperature of the first side of said thermoelectric generator brake pad (12),
- a control element capable of communicating with the temperature sensor and capable of switching between a first operating mode being a charging mode and a second operating mode being a control mode, where the thermoelectric generator in the first operating mode is capable of generating electricity, and in the second operating mode is controlling the temperature of the brake pad.

2. A system according to claim 1, wherein the thermoelectric generator elements are integral parts of the vehicle brake pad.

3. A system according to any of claims 1 or 2, where the brake rotor (10) is at one of the following brake rotors: a brake disc of a disc brake system or a brake drum of a drum brake system.

4. A system according to any of claims 1 to 3, wherein the thermoelectric generator elements are p (1a) and n (1b) semiconductor legs.

5. A system according to any of claims 1 to 4, wherein the system comprises;
- a converter in electrical connection with the thermoelectric generator and a vehicle battery.

6. A system according to any of claims 1 to 5, wherein the system comprises;
- a sensor element, which can feed back a signal to an electrical system indicating that the brake pad has become too thin and should be changed due to wear.

7. A vessel compring a system according to any of claims 1-6, said vessel being a land-based vehicle being selected among one of the following vehicles: a gasoline-powered car or a a partly or fully electrically powered car, a truck, a bus, a railway carriage, an electrical trolley for transporting people or goods such as a golf trolley, a goods troelly of, e.g, a warehouse or a wheel chair, a fully or partly electrically powred forklift-truck, a partly or fully electrically power bicycle.

8. A plant comprising a system according to any of claim 1-6, said plant being being selected among one of the following plants: a wind turbine and where the battery is a failsafe power supply of the wind turbine, a machining tool working machine and where the battery is a failsafe power supply of the working machine.

## Patentansprüche

1. System zum Erzeugen von Strom in einem Fahrzeug oder einer Anlage, wobei dieses System umfasst:
- einen thermoelektrischen Generatorbremsbelag (12) mit einer ersten Seite, die zu einem Bremsrotor (10) weist, der sich während des Betriebs des Fahrzeugs oder der Anlage dreht, wobei der thermoelektrische Generatorbremsbelag (12) eine zweite Seite aufweist, die in thermischem Kontakt zu einem Bremskörper steht,
- wobei der thermoelektrische Generatorbremsbelag eine Vielzahl von thermoelektrischen Generatorelementen (1) umfasst, die Strom aus Wärme erzeugen, die an der Oberfläche eines Bremsbelags erzeugt wird, wenn dieser mit dem sich drehenden Bremsrotor (10) in Kontakt ist,
- eine Vielzahl von thermischen Verbindungselementen (4) mit einer ersten Seite in thermischem Kontakt mit den Halbleiterbeinen p (1a) und n (1b) des thermoelektrischen Generators und einer zweite Seite in thermischem Kontakt mit dem Bremsrotor, wenn der Bremsbelag des Fahrzeugs während des Bremsens des Fahrzeugs selbst oder während des Bremsens einer Komponente des Fahrzeugs oder der Anlage mit dem Bremsrotor (10) in Eingriff ist,
- wobei das System dazu beschaffen ist, während des Bremsens des Bremsrotors, was zu einer Übertragung von Wärme von der ersten Seite des Bremsbelags auf die zweite Seite des Bremsbelags und weiter auf den Bremskörper führt, Strom zu erzeugen; wobei das System weiterhin umfasst:
- einen Temperatursensor, der eine Anzeige einer Temperatur der ersten Seite des thermoelektrischen Generatorbremsbelags (12) bereitstellen kann,
- ein Steuerungselement, das mit dem Temperatursensor kommunizieren kann und zwischen einem ersten Betriebsmodus, der einen Lademodus darstellt, und einem zweiten Betriebsmodus, der einen Steuermodus darstellt, umschalten kann, wobei der thermoelektrische Generator im ersten Betriebsmodus in der Lage ist, Strom zu erzeugen, und im zweiten Betriebsmodus die Temperatur des Bremsbelags steuert.

2. System nach Anspruch 1, bei dem die thermoelektrischen Generatorelemente feste Bestandteile des Bremsbelags des Fahrzeugs sind.

3. System nach einem der Ansprüche 1 oder 2, bei dem der Bremsrotor (10) sich an einem der folgenden Bremsrotoren befindet: einer Bremsscheibe eines Scheibenbremssystems oder einer Bremstrommel eines Trommelbremssystems.

4. System nach einem der Ansprüche 1 bis 3, bei dem die thermoelektrischen Generatorelemente die Halbleiterbeine p (1a) und n (1b) sind.

5. System nach einem der Ansprüche 1 bis 4, wobei das System umfasst:
- einen Wandler, der mit dem thermoelektrischen Generator und einer Fahrzeugbatterie elektrisch verbunden ist.

6. System nach einem der Ansprüche 1 bis 5, wobei das System umfasst:
- ein Sensorelement, das ein Signal an ein elektrisches System zurücksenden kann, um anzuzeigen, dass der Bremsbelag zu dünn geworden ist und aufgrund von Verschleiß ausgewechselt werden muss.

7. Fahrzeug umfassend ein System nach einem der Ansprüche 1 bis 6, das ein landgebundenes Fahrzeug, ausgewählt aus der folgenden Fahrzeuge: ein benzinbetriebenes Auto oder ein teilweise oder vollständig elektrisch betriebenes Auto, ein Lastkraftwagen, ein Bus, ein Eisenbahnwagen, ein elektrischer Transportwagen zum Befördern von Personen oder Gütern, wie ein Golfwagen, ein Warentransportwagen, zum Beispiel für ein Warenlager, oder ein Rollstuhl, ein teilweise oder vollständig elektrisch angetriebener Gabelstapler, ein teilweise oder vollständig elektrisch angetriebenes Fahrrad.

8. Anlage umfassend ein System nach einem der Ansprüche 1 bis 6, wobei die Anlage ausgewählt ist aus der folgenden Anlagen: eine Windkraftanlage, bei der die Batterie eine ausfallsichere Stromversorgung der Windkraftanlage darstellt, eine Werkzeugmaschine, bei der die Batterie eine ausfallsichere Stromversorgung der Werkzeugmaschine darstellt.

## Revendications

1. Système de production d'électricité dans un moyen de transport ou dans une installation, ledit système comprenant :
- une plaquette (12) de frein de générateur thermoélectrique ayant un premier côté faisant face à un rotor (10) de frein en rotation pendant le fonctionnement du moyen de transport ou de l'installation, et ladite plaquette (12) de frein de générateur thermoélectrique ayant un deuxième côté en contact thermique avec un corps de frein,
- ladite plaquette de frein de générateur thermoélectrique comportant une pluralité d'éléments (1) de générateur thermoélectrique produisant de l'électricité à partir de la chaleur produite sur la surface d'une plaquette de frein lorsqu'ils sont en contact avec ledit rotor (10) de frein en rotation,
- une pluralité d'éléments (4) de liaison thermique présentant un premier côté en contact thermique avec les pattes p (1a) et n (1b) semi-conductrices du générateur thermoélectrique et un deuxième côté en contact thermique avec le rotor de frein lorsque la plaquette de frein du véhicule est en prise avec le rotor (10) de frein lors d'un freinage du moyen de transport lui-même ou pendant un freinage d'un composant du moyen de transport ou de l'installation,
- ledit système adapté pour produire de l'électricité lors du freinage du rotor de frein entraînant le transfert de chaleur depuis le premier côté de la plaquette de frein vers le deuxième côté de la plaquette de frein, puis sur le corps de frein ; dans lequel le système comprend en outre :
- un capteur de température capable de fournir une indication d'une température du premier côté de ladite plaquette (12) de frein de générateur thermoélectrique,
- un élément de régulation capable de communiquer avec le capteur de température et de basculer entre un premier mode de fonctionnement étant un mode de charge et un deuxième mode de fonctionnement étant un mode de régulation, où le générateur thermoélectrique est capable de produire de l'électricité dans le premier mode de fonctionnement et de réguler la température de la plaquette de frein dans le deuxième mode de fonctionnement.

2. Système selon la revendication 1, dans lequel les éléments de générateur thermoélectrique font partie intégrante de la plaquette de frein du véhicule.

3. Système selon l'une quelconque des revendications 1 ou 2, dans lequel le rotor (10) de frein se situe au niveau de l'un des rotors de frein suivants : un disque de frein d'un système de frein à disque ou un tambour de frein d'un système de frein à tambour.

4. Système selon l'une quelconque des revendications 1 à 3, dans lequel les éléments de générateur thermoélectrique sont des pattes p (1a) et n (1b) semi-conductrices.

5. Système selon l'une quelconque des revendications 1 à 4, dans lequel le système comprend :
- un convertisseur en liaison électrique avec le générateur thermoélectrique et une batterie de véhicule.

6. Système selon l'une quelconque des revendications 1 à 5, dans lequel le système comprend :
- un élément de détection capable d'envoyer à un système électrique un signal de réaction indiquant que la plaquette de frein s'est trop amincie et doit être remplacée pour cause d'usure.

7. Moyen de transport comprenant un système selon l'une quelconque des revendications 1 à 6, ledit moyen de transport étant un véhicule terrestre choisi parmi les véhicules suivants : une voiture à essence ou à alimentation électrique partielle ou entière, un camion, un autobus, un wagon de chemin de fer, un chariot électrique de transport de passagers ou de marchandises, comme un chariot de golf, un chariot de marchandises, par exemple un chariot d'entrepôt, ou un fauteuil roulant, un chariot élévateur à fourche à alimentation électrique partielle ou entière, un vélo à alimentation électrique partielle ou entière.

8. Installation comprenant un système selon l'une quelconque des revendications 1 à 6, ladite installation étant choisie parmi les installations suivantes : une éolienne, dont la batterie est une alimentation à sécurité intrinsèque de l'éolienne, une machine à travailler de type machine-outil, dont la batterie est une alimentation à sécurité intrinsèque de la machine à travailler.
